# EUROPEAN PATENT SPECIFICATION

(11) **EP 2 346 265 B1**
(45) Date of publication and mention of the grant of the patent: **09.10.2019**
(21) Application number: 09820173.4
(22) Date of filing: 17.06.2009
(51) Int. Cl.: H04R 1/10

(54) **SAFETY EARPHONE DEVICE**
SICHERHEITSOHRHÖRER
DISPOSITIF D'ÉCOUTEUR DE SÉCURITÉ

(30) Priority: 15.10.2008 CN 200810167226
(43) Date of publication of application: 20.07.2011
(73) Proprietor: Zhu, Aidao, Zhejiang Province 325011 (CN)
(72) Inventor: Zhu, Aidao, Zhejiang Province 325011 (CN)
(74) Representative: Dennemeyer & Associates S.A.
(86) International application number: PCT/CN2009/000660
(87) International publication number: WO 2010/043097

(56) References cited:
- WO-A1-03/103335
- CN-A- 101 227 756
- CN-A- 101 227 756
- CN-Y- 2 454 999
- CN-Y- 2 648 746
- JP-A- 2002 165 289
- US-A- 4 090 042
- US-A- 4 677 679
- US-A- 5 410 608
- US-A1- 2001 027 089
- US-A1- 2002 055 374

## Description

### Field of the Invention

The present invention relates to a radiation-proof or safe earphone device, and specifically to an anti-radiation earphone device and a stereo radiation-proof which are used for communication devices with high frequency magnetic field and intense radiation, such as a mobile phone. And more particularly, the invention relates to an earphone device which effectively improves the frequency response and is capable of generating a better stereo sound effect.

### Background of the Invention

An ordinary earphone, such as the one along with in a mobile phone, includes a plug, a conductive wire and earphone head, with the earphone having micro-loudspeakers installed therein. Since people directly use the phone to listen and talk, the super high frequency magnetic field or other harmful radiation caused by the mobile phone will severely stimulate brain nerves of people, hurting people's health. Usually, people use earphone device to answer a call in order to reduce the harm caused by many kinds of radiation rays such as super high frequency magnetic field, and electric wave and thermal energy. However, using the common earphone with a speaker directly mounted in the earphone heads is still unable to avoid the danger from transmitting the radiation rays such as the super high-frequency magnetic field to the ears and up into the brain. In addition, such earphone heads with loudspeakers mounted therein have the permanent magnetic field up to 1600G, which also have drastic harm to people's brain. So, using frequently such mobile phone or the earphones for a long time can easily cause symptoms of headache, dizziness, numbness, *etc.*

An existing radiation-proof earphone for instance, a product called as "radiation-free earphone" with patent number ZL02244828.4 can reduce electromagnetic radiation, however, its sound wave channel is too short, only 5-10cm, which can not reach the requirement of 2mG or less. The purpose of being controlled as 2mG or less is provided according to the theory of the inventor of the cell phone, Professor Shi Min of Taiwan Communication University, PhD of Stanford University in US, academician of American Academy of Engineering due to the harm to human by magnetic field. So the existing earphone cannot meet the requirement of anti-electromagnetic radiation as mentioned above. Meanwhile it has no sound cavity, thus frequency response is not good. The application No. 200610028981.6, entitled "Safe Earphone Device", applied by the present inventor, discloses a safe earphone device which although discloses a sound wave transmission passage, however does not disclose a specific length of the sound wave transmission channel. The present inventor applied afterwards a Chinese patent publication No. CN 101227756A, entitled "Safe Earphone device", Publication Date of July 23, 2008, discloses the specific length of the sound wave transmission channel, but it does not disclose the sound wave collecting slot, sound wave-division passage, airproof of speaker, and tightening between switch and sound wave transmission passage. Document US2002/055374 discloses an earphone head wherein the micro-loudspeaker radiates in a sound collecting cavity.

Therefore, people extraordinarily need an earphone device which can prevent electromagnetic radiation and have a better frequency response, and have a better stereo effect.

### Summary of the Invention

The object of the present invention is to provide a safe earphone device which can avoid the damage to people's brain and body caused by super high-frequency magnetic field, electric wave and thermal energy radiation. In addition, it also has a better frequency response i.e., the frequency response is effectively improved and improved stereo effect.

To address the problems stated above, the present invention according to claim 1 sets the loudspeakers and the earphones separately. And the sound wave transmission channels with the following length and the sound cavities with the following volume are placed between micro loudspeakers and earphones, such that the sound produced by the micro loudspeaker are transmitted into people' s ears via the sound wave transmission channels and sound cavity body. Especially, in the present invention, a sound collecting slot is added, and at the same time, the speaker and the sound wave transmission channel port are together sealed in a small box in the main body. On one hand, all sound waves produced by the micro loudspeaker can be efficiently collected by the sound wave collecting slot that is a reversed trumpet shape to effectively pass through the sound wave channel, so as to be sent into people's ears. The above-mentioned process not only reduces power loss but also improves the frequency response. On the other hand, this process will not disturb a microphone as the microphone is located in the main body. There is a switch 12 added. Since the signal intensity is at highest level at the instant of picking up a call, it is possible to pick up the call by pressing the switch with the mobile phone being away, which efficiently protect people's brain and other organs from the damage of the radiation caused by the strong radiation when answering a phone call. One loudspeaker separately transmits with two sound wave transmission channels such that two ears can listen simultaneously, which produces a brilliant stereo effect.

Technical solutions of the invention are achieved according to the features claimed in claim 1.

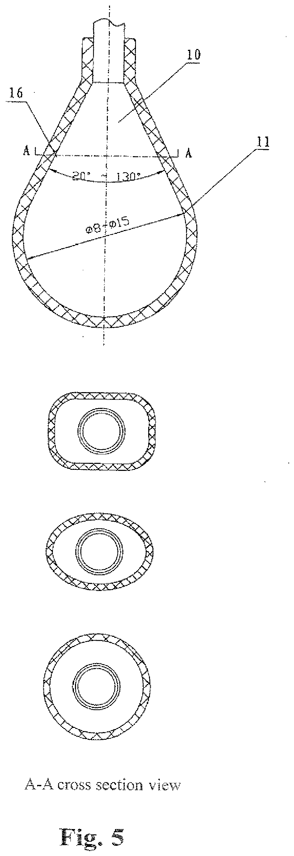

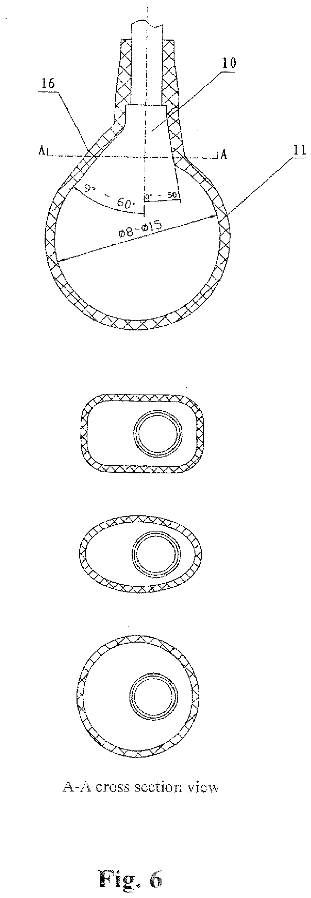

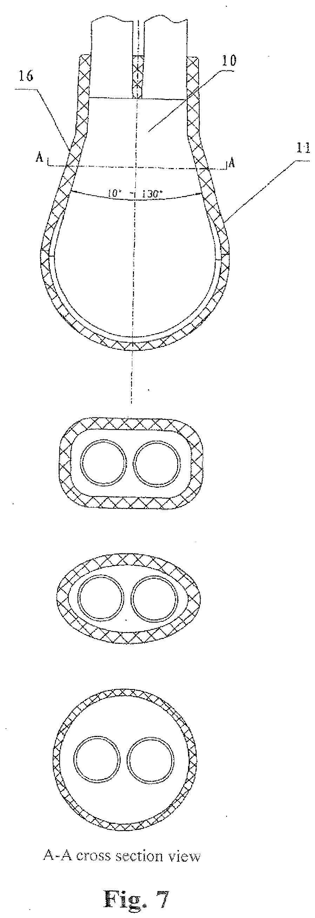

A safety earphone comprises an earphone head with cover 1, a sound cavity 2, a sound wave transmission channel 3, a main body 4, a micro-loudspeaker 5 or called as loudspeaker 5, a microphone 6, a conductor 8 and a plug 9, wherein the sound wave transmission channel 3 is placed between the sound cavity 2 and the micro-loudspeaker 5, the micro-loudspeaker 5 has round or ellipse shape, the sound wave transmission channel 3 is a length of slim soft hose or rigid tube, which is made of insulating material, the micro-loudspeaker 5 and microphone 6 are placed in the main body 4; the main body 4 and the micro-loudspeaker 5 are located at one end of the sound wave transmission channel 3 while the earphone head with cover 1 at the other end. The slim channel in the middle is the sound wave transmission channel 3. The micro-loudspeaker 5, microphone 6, conductor 8 and plug 9 are connected in sequence; the conductor is made of metal shielding wire, the length of the sound wave transmission channel 3 is between 110mm and 600 mm or between 155 mm and 600 mm, the inner diameter of the sound wave transmission channel 3 is between 2 mm and 4 mm; the volume of the sound cavity 2 is between 600 mm³ and 3000 mm³; the outlet of the sound cavity 2 is provided with one hole with the diameter Φ of between 1.5mm and 4mm or several small holes with each hole having the diameter Φ of between 0.3mm and 1.5mm, so that the sound cavity forms a small sound box, wherein:
1) A sound collecting cavity 10 is added between the micro-loudspeaker 5 and the sound wave transmission channel 3; a small sealed box 11 is placed in the main body 4 for sealing the periphery of the sounding end of the loudspeakers 5, the sound collecting cavity 10, and the sound wave transmission channel slot at the joint, such that the sound wave from the loudspeaker 5 can be smoothly transmitted to the earphone through the sound collecting cavity 10 and then through the sound wave transmission channel 3, thus the sound is heard by ears. The microphone 6 and a switch 12 are mounted in the main body 4, the sound collecting cavity 10 is of inversed taper shape, the angles between bevel edges of the two pairs at the periphery of the sound collecting cavity 10 peripheral are symmetrical. And the angles between bevel/arc/curve edges of the two pairs at the periphery of the sound collecting cavity 10 are symmetrical between 9° and 130°; both of the two pairs of angles are of inversed taper shape, or one pair is of inversed taper shape while the other one is parallel; the cross section of the cone of the taper shape or the cross section parallel to the bottom of the cone is made of rectangle or polygon shape with the four corners of round or right angle, or the cross section is made of ellipse shape or the cone has the big end of the rectangle shape and the small end of round shape, (as Figs. 5, 6 and 7). The above mentioned angle is between 9 ° and 130° means that when the angle is 9 °, the angle between the bevel/arc/curve edges of the two pairs and the centerline is 4.5° and when the angle is 130°, the angle between the bevel/arc/curve edges of the two pairs and the centerline is 65°, or the angles between the bevel/arc/curve edges of the two pairs at the periphery of the sound collecting cavity 10 and the centerline are unsymmetrical and between 1°-65° and between 65°-1° respectively, wherein the unsymmetrical angels of between 1°-65° and between 65°-1° mean that the respective angles of the bevel/arc/curve edges of the two pairs at the periphery of the sound collecting cavity 10 and the centerline are unsymmetrical, which means that the angle between the left bevel/arc/curve edge and the centerline is 1°-65°, while the angle between right bevel/arc/curve edge and the centerline is 65°-1°, or the angle between the left bevel/arc/curve edge and the centerline is 65°-1°, while the angle between right bevel/arc/curve edge and the centerline is 1°-65°;
2) Using one micro-loudspeaker 5, the sound produced by the micro-loudspeaker 5 is transmitted to two sound wave transmission channels via the sound collecting cavity 10 and dividing fittings, so that it is heard by ears with the earphones inserted;
3) The above loudspeaker is sealed in a small sealed box, the microphone is mounted in one circle hole in the main body with its sound receiving surface facing outward and the periphery sealed so that the sound can be transmitted to the microphone only through one or more sound receiving holes in the main body and then through one or more sound receiving small holes in front of the sound receiving face of the microphone, therefore, the interference of the loudspeaker on the microphone is eliminated, such that there is no echo or noise produced in the microphone;
4) To improve the tensile strength of the earphone, it is needed to tighten the sound wave transmission channel, which is performed by any one of the two ways as follows:
   (1) The sound wave transmission channel 3C has one end fixed in the earphone's inlet and the other end fixed in the main body's outlet, and the slot at two ends of the sound wave transmission channel 3C is bulged by a hollow rivet 17-1, so that the sound wave transmission channel is fixed at the earphone's inlet end and the main body's outlet end;
   (2) One end of the sound wave transmission channel is inserted over the earphone's inlet and the other end thereof over the main body's outlet, and then a jacket 17-2 is used to be inserted over the external diameter of the ends of the sound wave transmission channel, for tightening.

To sum up, the sound collecting cavity is a cone body formed by straight line, arc line or curve line, wherein the upper portion of the cone body is cut away, that is truncated cone (its shape). The cone body perfectly collects the sound wave into the sound wave transmission channels.

The above earphone is characterized in that the sound collecting cavity 10 is of inversed taper shape which represents one of the followings:
1) the inversed taper shape with the peripheral formed by arc lines;
2) the inversed taper shape with the peripheral formed by bevel lines;
3) the inversed taper shape with the peripheral formed by curve lines;
4) the inversed taper shape with the peripheral formed by arc (or curve) lines and bevel lines together;

The angles between the bevel/arc/curve edges of the two pairs at the periphery of the sound collecting cavity 10 and the central line are the unsymmetrical angles of 60°, which means that the angles between the bevel/arc/curve edges of two pairs at the periphery of the sound collecting cavity 10 and the centerline are unsymmetrical wherein the angle between the left bevel/arc/curve edge and the centerline is 51° while the angle between the right bevel/arc/curve edge and the centerline is 9°, or vice versa.

The above earphone is characterized in that the angles between the bevel/arc/curve edges of two pairs at the peripheral of sound collecting cavity 10 and the centerline are unsymmetrical angles of 40°, meaning that the angles between the bevel/arc/curve edges of two pairs at the periphery of the sound collecting cavity 10 and the centerline are unsymmetrical wherein the angle between the left bevel/arc/curve edge and the centerline is 35° while the angle between the right bevel/arc/curve edge and the centerline is 5°, or vice versa.

The above earphone is characterized in that the micro-loudspeaker 5 is placed vertically in the main body.

The above earphone is characterized in that the micro-loudspeaker 5 is placed flatly or slantwise in the main body.

The above earphone is characterized in that the micro-loudspeaker 5 is of round or ellipse shape.

The radiation-proof safety earphone device of the present invention can also be used for MP3 or MP4, which can produce very rich bass when music being played.

Advantages of the safety earphone device in the present invention compared with the existing earphone device are as follows:
1. The earphone device of the present invention is an improved invention based on the present applicant's application whose application number is CN200810000676.5, titled as "an earphone device" in 2008. So the earphone device of the present invention has all advantages that the previous invention of earphone device has. For instance, the radiation intensity into human ears is limited to 2mG or less, the target set in one of cell phone inventors Professor Shi Min' theory, as its sound wave transmission channels are lengthened. For example, it reaches the requirement of 1.8 mG or less, which effectively avoids the harm to human brain body by electromagnetism radiation.
2. Since a sealing small box is additionally provided in the main body, the three of the loudspeakers, the wound wave collecting slot and the sound wave transmission channel port are sealed at their joint positions into the sealing small box. As the sound collecting cavity is additionally provided between the micro-loudspeakers and the sound wave transmission channels, it improves tremendously the response of high and low frequency range, which make the sound distortion very little. Otherwise, if no sound collecting cavity is provided, the attenuations of both high and low frequency ranges are very huge, causing no power output. As a result, serious sounding distortion will happen.
3. In the present invention, there is a speaker sealing small box added, which seals the should wave generated by the speaker, such that the sound waves all pass through the sound wave collecting cavity and are all smoothly transmitted to the sound wave channel. Also, as the speakers are sealed in a speaker sealing small box; the microphone is mounted in a circle hole in the main body. The microphone has outward sound receiving surface and the sealed edge, so that the sound only can firstly pass through the receiving hole or holes of the main body and then is transmitted to the microphone through the receiving small hole or holes in the front face of the sound receiving surface of the microphone. Thus, it eliminates the interference of the speaker to the microphone, such that no disturbing echo or noise will occur in the microphone, as the speaker and the microphone are both mounted in the main body.
4. In the present invention, there a sound wave collecting cavity added, so as to improve frequency response, as the sound wave generated by the micro loudspeaker is collected by the sound collecting cavity i.e. inversed trumpet shape or frustum shape, so as to be transmitted to the sound wave channel, and then to the ears of human. This process improves the frequency response.
5. Secondly, one switch is added in the main body. With such switch, it is possible to allow the mobile phone away from the human body when the signal is strongest at the moment of answering a phone call, therefore the maximum anti-radiation effect is obtained and the harm of the radiation to human brain, body and other organs is effectively prevented.
6. One loudspeaker which can be shared by two ears of one person produces a stereo sounding effect, or two person use two earphones respectively, lowering the cost, which especially suit for the young.
7. In addition, compared to the existing art in which two loudspeakers are used, since in one example of the present invention, only one speaker is used, which render smaller volume of the case, and at the same time, when using only one speaker, it is possible to use a speaker with a large diameter, which results in a better low frequency response and reduced cost.
8. Due to the above two kinds of fastening modes, anti-tensile or tensile strength of the earphone device is greatly increased, and is up to 2kg or more.

To further testify radiation-proof effect of the earphone device of the present invention, Aidao Zhu from Shanghai Zhongchangjiang Automobile Electronic Appliances Co., Ltd is both the legal representative of the company and the applicant and inventor of the invention, who entrusts Shenzhen Centre Testing International Corporation CTI to carry out contrast test for electromagnetic radiation intensity of FMJ radiation-proof communication device -the safe earphone device according to the present invention, a mobile phone and an ordinary earphone. The test was performed on May 15^{th}, 2008 wherein the test instrument adopted is made by ETS-LINDGREN in America.

The specific test method is as follows:
1. Testing the background noise of the environment by using the peak detection mode and max maintaining function, with 10 seconds of the probe head scanning, and recording the result into a report;
2. Placing a test earphone on a test table of 80cm height wherein the test probe head is positioned 2mm away from both a mobile phone and the earphone head;
3. Keeping the magnetic field probe head stationary and placing horizontally the mobile phone and the earphone head at 2mm far from the probe head. referring to the contrast test report of electromagnetic radiation intensity for FMJ radiation-proof communication device, mobile phone and the ordinary earphone for details of a layout view of the test earphones and FMJ radiation-proof communication device.

Test Mode: by the peak detection and the maximum maintaining function probe head scanning for 10 seconds, reading the data and recording it into a corresponding table, when the mobile phone in the normal standby, in normal communication, in the moment of answering a call, in the case that the mobile phone make a call but the other side does not answer, and in the case that a call is coming in but not answered yet.

### Test Data:

Ambient noise: 0.68 µW/cm2
1, Placing the FMJ radiation-proof communication device earphone head right in front of the magnetic field probe head at the horizontal distance of 2mm, making the test according to the following mode as follows and recording readings; and placing the mobile phone aerial terminal in front of the magnetic field probe head at the horizontal distance of 2mm, making the test according to the mode as follows and recording readings. The test data is as that in Table 1: 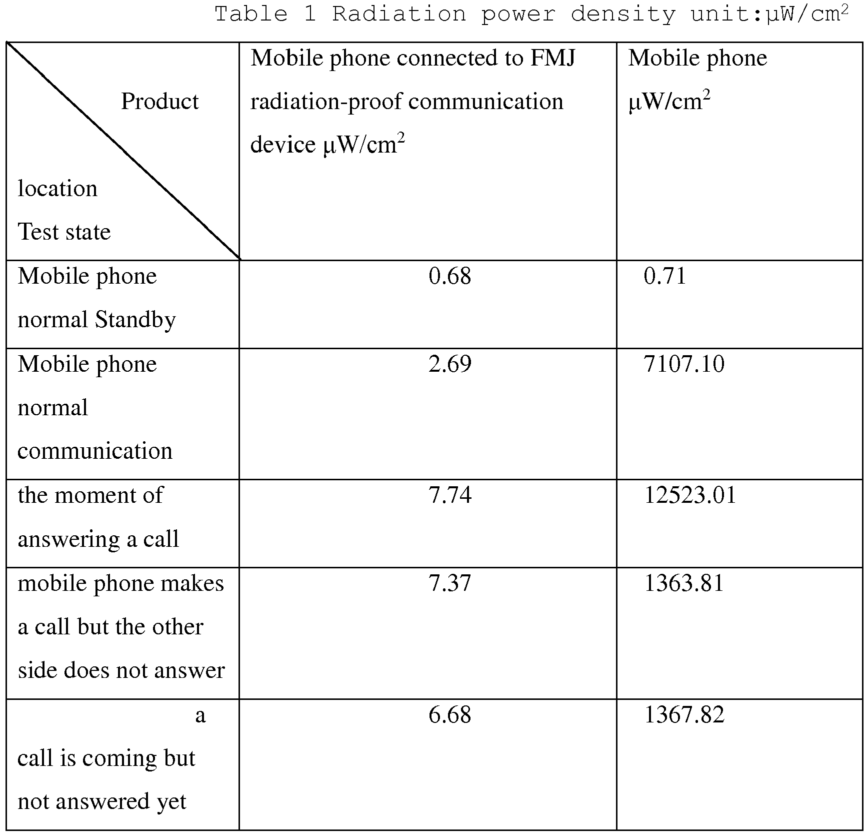
2. Placing the FMJ radiation-proof communication device earphone head right in front of the magnetic field probe head at the horizontal distance of 2mm, making the test according to the mode as follows and recording readings; and Placing the ordinary earphone earphone head in direct front of the magnetic field probe head at the horizontal distance of 2mm, making the Test according to mode as follows and recording readings. The test data is as that in Table 2.

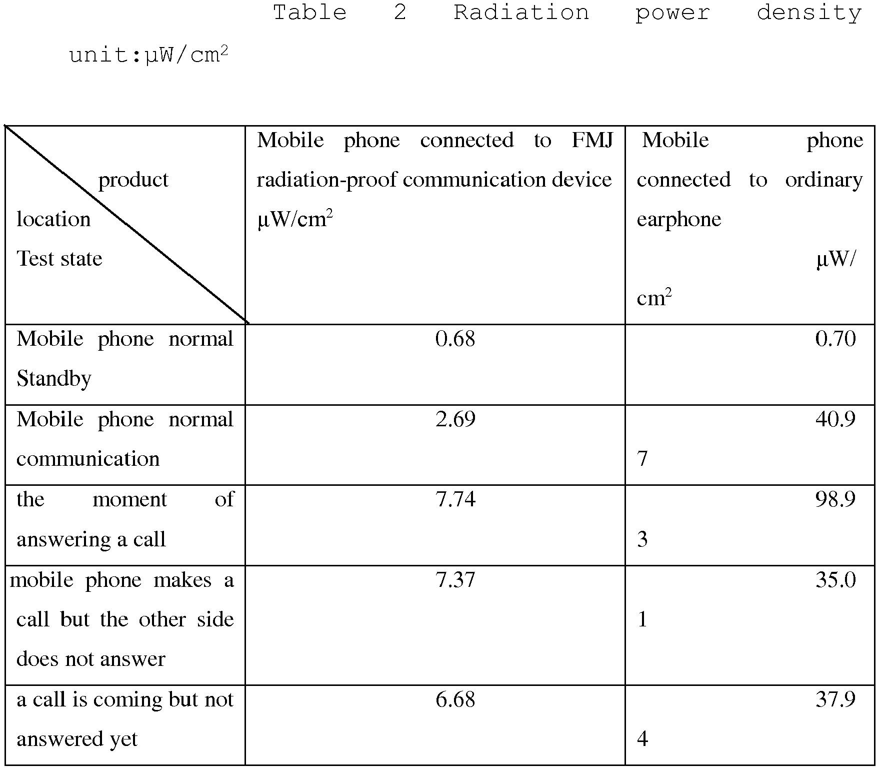

### Discussion:

1. We found from Table 1 that when the FMJ radiation-proof communication device i.e., the safety earphone of the present invention being compared with the mobile phone, beside that on the standby mode the radiation power intensity of mobile phone connected to FMJ radiation-proof communication device is reduced to 0.96 times of that of the mobile phone, other radiation power intensity is reduced substantially, wherein when the mobile phone is in normal communication, the radiation power intensity of mobile phone connected to FMJ radiation-proof communication device is reduced to 0.00038 times of that of mobile phones; when the mobile phone in the moment of answering a call, the radiation power intensity of mobile phone connected to FMJ radiation-proof communication device is reduced to 0.00062 times of that of mobile phone; when mobile phone makes a call but the other side does not answer, the radiation power intensity of mobile phone connected to FMJ radiation-proof communication device is reduced to 0.0054 times of that of mobile phone; and when a call is coming but not answered yet, the radiation power intensity of mobile phone connected to FMJ radiation-proof communication device is reduced to 0.0049 times of that of mobile phone.
   Obviously, during the normal communication of the mobile phone in, the moment of answering a call, mobile phone making a call but the other side not answer and a call coming in but not answered yet, the radiation power intensity has great reduction.
2. We found from Table 2 that beside that on the standby mode the radiation power intensity of the mobile phone connected to FMJ radiation-proof communication device is reduced to 0.97 times of that of mobile phone connected to the ordinary earphone, when the FMJ radiation-proof communication device i.e., the safety earphone of the present invention being compared with the ordinary earphone, radiation power intensity is reduced substantially, wherein when the mobile phone is in normal communication, the radiation power intensity of the mobile phone connected to FMJ radiation-proof communication device is reduced to 0.0657 times of that of mobile phone connected to the ordinary earphone; when the mobile phone in the moment of answering a call, the radiation power intensity of the mobile phone connected to FMJ radiation-proof communication device is reduced to 0.078 times of that of mobile phone connected to the ordinary earphone; when mobile phone makes a call but the other side does not answer, the radiation power intensity of the mobile phone connected to FMJ radiation-proof communication device is reduced to 0.211 times of that of mobile phone connected to the ordinary earphone; and when a call is coming but not answered yet, the radiation power intensity of the mobile phone connected to FMJ radiation-proof communication device is reduced to 0.176 times of that of mobile phone connected to the ordinary earphone.

Obviously, during the normal communication of the mobile phone in the moment of answering a call, the radiation power intensity is reduced substantially, and when mobile phone making a call but the other side not answering and a call coming in but not answered yet, the radiation power intensity has certain reduction.

As stated, using the FMJ radiation-proof communication device i.e., the safety earphone device of the present invention, the human brain and other organs of human being is subject to much reduced radiation intensity, such the harm caused by radiation to human brain and body can be reduced substantially. Therefore, the safety earphone device of the present invention indeed attains super radiation-proof effects, super environment friendly benefits and society benefits.

### Brief Description of the Drawings

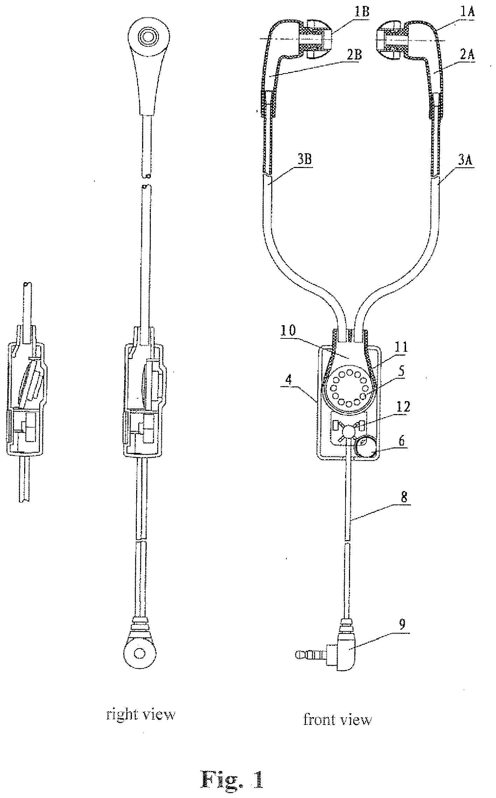

Fig. 1 is a schematic view of the earphone device according to the present invention, having two sound wave transmission channels and one loudspeaker placed flatly or slantwise;

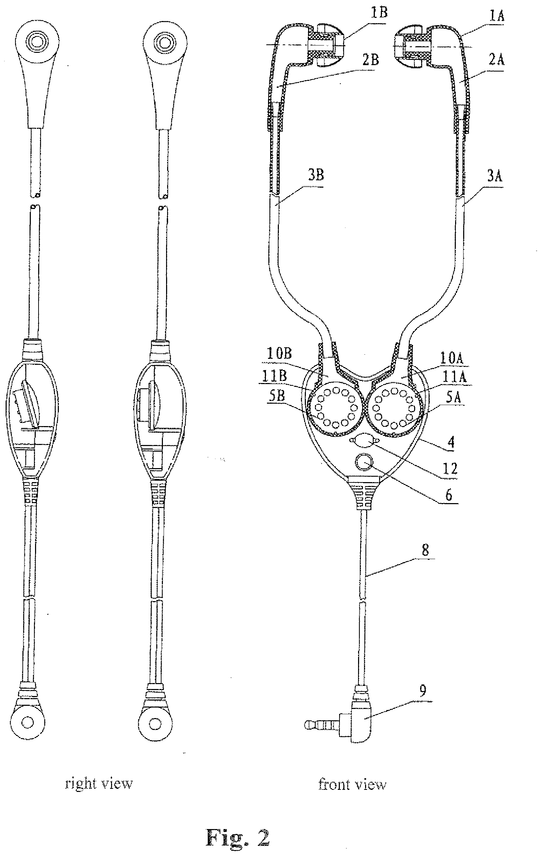

Fig. 2 is a schematic view of the earphone device according to the present invention, having two loudspeakers placed flatly or slantwise and unsymmetrical sound collecting cavity;

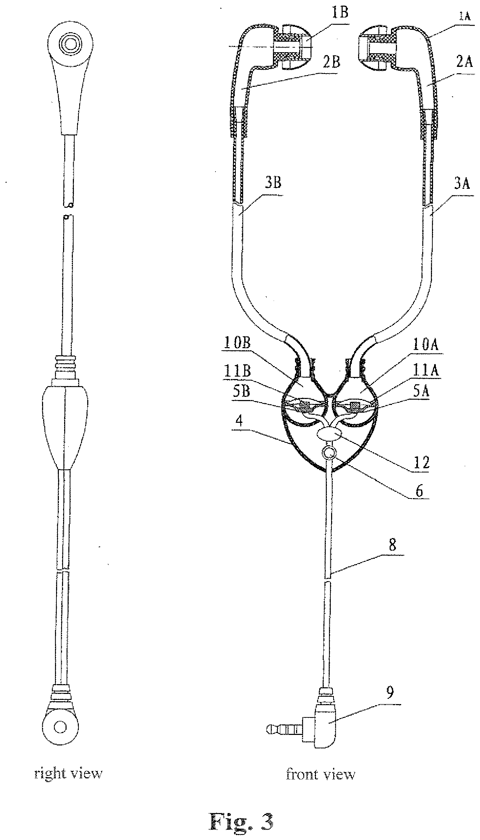

Fig. 3 is a schematic view of the earphone device according to the present invention, having two loudspeaker placed vertically and sound collecting cavity;

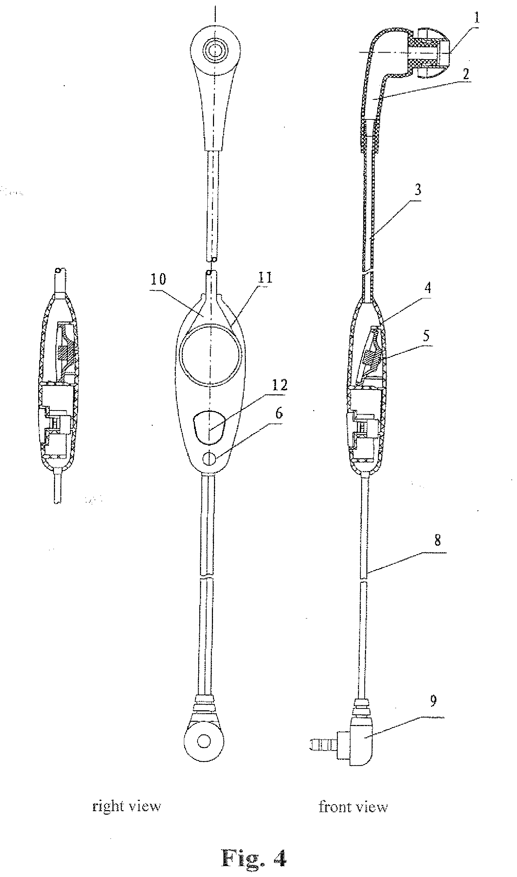

Fig. 4 is a schematic view of the earphone device according to the present invention, having one loudspeaker placed flatly or slantwise and symmetrical sound collecting cavity;
Fig. 5 is a schematic view of a small sealed box with one loudspeaker, one sound wave transmission channel and the symmetrical sound collecting cavity according to the present invention, wherein the angle between the bevel/arc/curve edges of two pairs at the periphery of the sound collecting cavity 10 is symmetrical angle of 20°-130°, wherein there are three A-A cross section views, with the cross section views having the rectangle, ellipse, round, or polygon shape respectively the polygon section view is not illustrated;
Fig. 6 is a schematic view of a small sealed box with one loudspeaker, one sound wave transmission channel and the unsymmetrical sound collecting cavity according to the present invention, wherein the respect angles between the bevel/arc/curve edges of two pairs at the periphery of the sound collecting cavity 10 and the centerline are unsymmetrical angle of 9°-60°and 0°-50°, wherein there are three A-A cross section views, with the cross section views having the rectangle, ellipse, round, or polygon shape respectively (the polygon section view is not illustrated);
Fig. 7 is a schematic view of a small sealed box with one loudspeaker and two sound wave transmission channels according to the present invention, wherein the angles between the bevel/arc/curve edges of two pairs at the periphery of the sound collecting cavity 10 and the centerline are symmetrical angle of 10°-130°, wherein there are three A-A cross section views, with the cross section views having the rectangle, ellipse, round, or polygon shape respectively (the polygon section view is not illustrated);

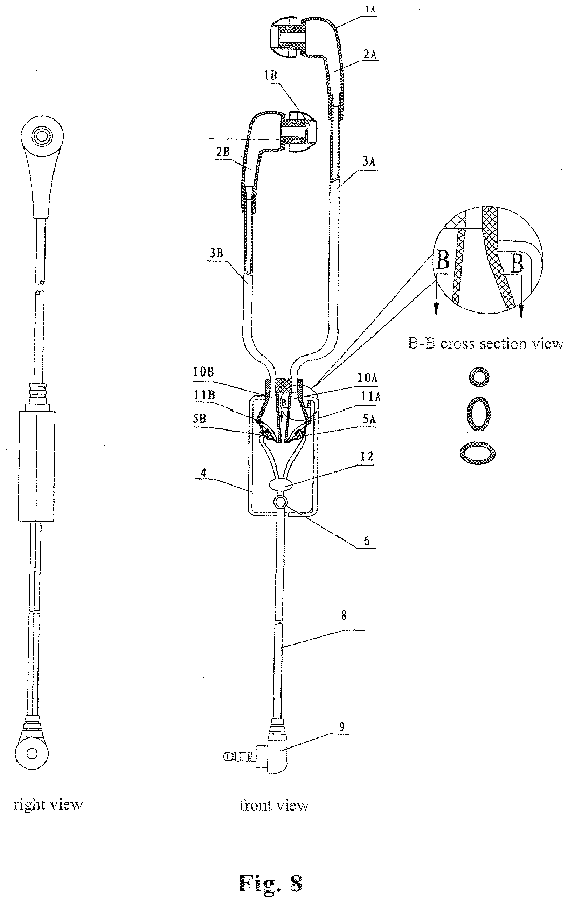

Fig. 8 is a schematic view of the rectangle-shaped earphone device according to the present invention comprising two loudspeakers placed vertically or slantwise and the sound collecting cavity having different shapes wherein the sound collecting cavities 10A and 10B can have different shapes; there are three B-B cross section views, with the cross section views having round, ellipse or polygon shape (the polygon section view is not illustrated);

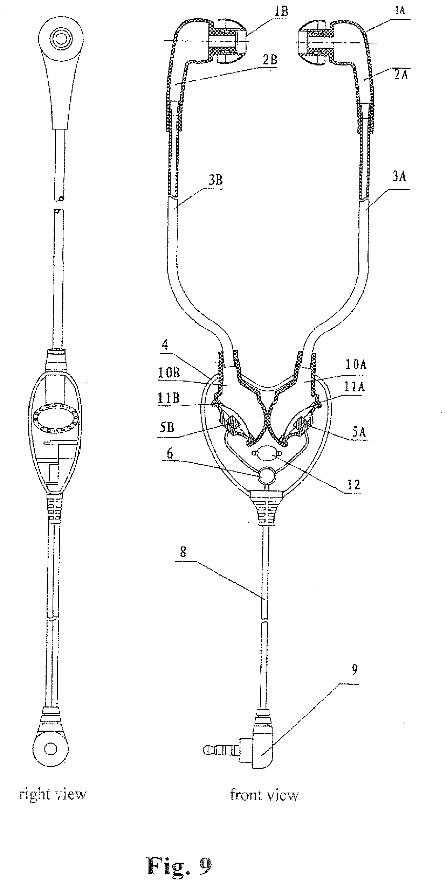

Fig. 9 is a schematic view of heart-shaped earphone device according to the present invention comprising two loudspeakers placed vertically or slantwise and the sound collecting cavities having different shapes;

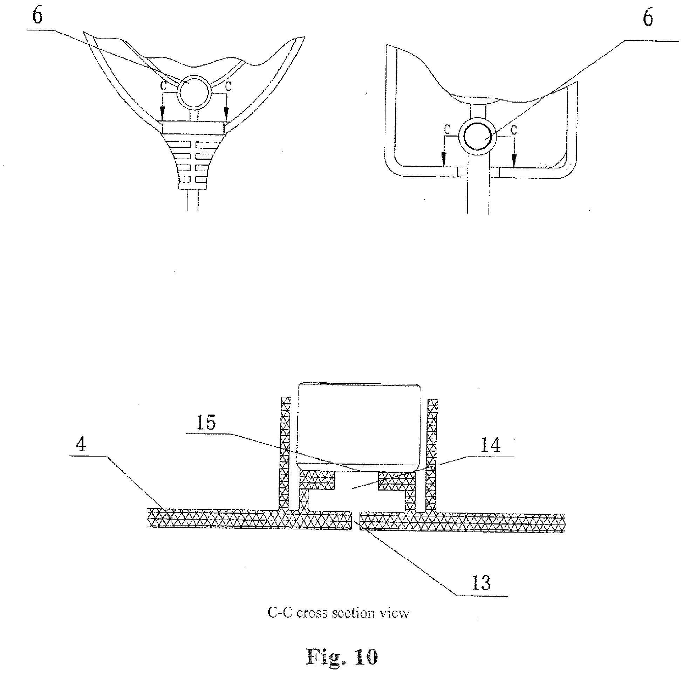

Fig. 10 is a C-C cross section of the microphone portion of Fig. 8 and Fig. 9;

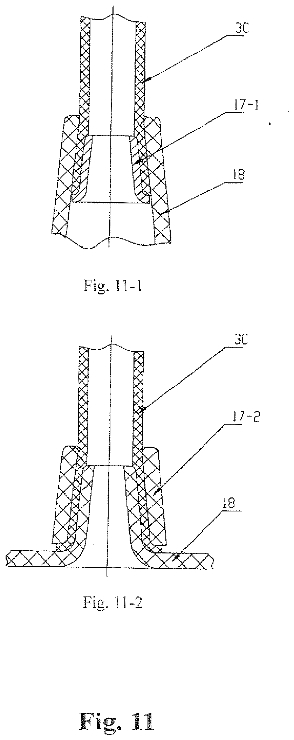

Fig. 11 is a schematic view illustrating the tightening ways of sound wave transmission channels of the present invention; wherein Fig. 11-1 is a schematic view illustrating the rivet fastening; Fig. 11-2 is a schematic view illustrating the sheath fastening.

In the above, 1, 1A, 1B are earphone head with cover, 2, 2A, 2B are sound cavities, 3, 3A, 3B, 3C are sound wave transmission channels, 4 is the main body, 5, 5A, 5B are micro-loudspeakers, 6 is the microphone, 8 is the conductor, 9 is the plug, 10, 10A, 10B are sound collecting cavities, 11, 11A, 11B are sealed boxes or small sealed boxes, 12 is a switch, 13 is sound receiver hole, 14 is sound receiving small holes, 15 is sound receiving face of microphone, 16 is arc or straight line, 17-1 is rivet, 17-2 is jacket, 18 is inlet or outlet end for sound wave.

### Detail Description of the Invention

### Embodiment 1

A safety earphone device comprises an earphone heads with covers 1, a sound cavity 2, sound wave transmission channels 3, a main body 4, micro-loudspeaker 5, a microphone 6, a conductor 8 and a plug 9, wherein the channels 3 are placed between the cavities 2 and loudspeakers 5 which are round or ellipse, the sound wave transmission channel 3 is a length of slim hose or rigid tube. The sound wave transmission channels 3 are made of insulating materials. The micro loudspeaker 5 and the microphone 6 are mounted in the main body 4 in form of one piece. The main body 4 and the micro loudspeaker 5 are located at one end of the sound wave transmission channel 3, while the earphone head with cover 1 at the other end. The slim channel in the middle is the sound wave transmission channels 3. The micro loudspeaker 5, the microphone 6, the conductor 8 and the plug 9 are connected in sequence. The conductor uses metal shielding line. The length of sound wave transmission channel 3 is 110mm; the inner diameter of sound wave transmission channel 3 is 2 mm, the volume of sound cavity 2 is 600mm³; the outlet of the sound cavity 2 is provide with one small hole of 1.5mm or several holes with each one having the diameter of 0.3 mm, so that sound cavity forms a small sound box.

The safety earphone device is characterized in:
1) A sound collecting cavity 10 is added between the micro-loudspeaker 5 and the sound wave transmission channel 3; a small sealed box 11 is placed in the main body 4, and the periphery of the sounding end of the loudspeakers 5, the sound collecting cavities 10, and the sound wave transmission channel slot are sealed at the joint into the small sealed box 11, the microphone 6 and a switch 12 are mounted in the main body 4, the sound collecting cavity 10 is of inversed taper shape, and the angles between bevel edges of the two pairs at the periphery of the sound collecting cavity 10 are symmetrical angle of 9°; both of the two pairs of angles are of inversed taper shape, or the angles of one pair thereof is of inversed taper shape while angles of the other pair is parallel; the cross section of the cone or the cross section parallel to the bottom of the cone is made of rectangle or polygon shape with the four corners of round or right angle, or the cross section is made of ellipse shape or the cone has the big end of the rectangle shape and the small end of round shape, wherein the case that the angle is 9 ° means that when the angle is 9 °, the angle between the bevel/arc/curve edges of the two pairs and the centerline is 4.5°, or the angle between the bevel/arc/curve edges of the two pairs at the periphery of the sound collecting cavity 10 and the centerline is unsymmetrical angle of 1°, 65°, wherein the unsymmetrical angle of, 65° means that the angles between the bevel/arc/curve edges of the two pairs at the periphery of the sound collecting cavity 10 and the centerline are unsymmetrical angle wherein the angles between left bevel/arc/curve edges and the centerline is 1° while the angle between right bevel/arc/curve edge and the centerline is 65°, or the angle between the left bevel/arc/curve edge and the centerline is 65°, while the angle between right bevel/arc/curve edge and the centerline is 1°.
2) Using one micro-loudspeaker 5, and the sound produced by the micro-loudspeaker 5 is transmitted to two sound wave transmission channels via the sound collecting cavity 10 and branch channel, such that it is heard by ears with the earphones inserted.
3) The above loudspeaker is sealed in a small sealed box, the microphone is mounted in one circle hole in the main body with its sound receiving surface facing outward and the periphery sealed, so that the sound can be transmitted to the microphone only through one or more sound receiving holes in the main body and then through one or more sound receiving small holes in front of the sound receiving face of the microphone, therefore, the interference of the loudspeaker on the microphone is eliminated, such that there is no echo or noise produced in the microphone.
4) To improve the tensile strength of the earphone, it is needed to tighten the sound wave transmission channel, which is performed by any one of the two ways as follows:
   The sound wave transmission channel 3C has one end fixed in the earphone's inlet and the other end fixed in the main body's outlet, and at the two ends of the sound wave transmission channel 3C is bulged by a hollow rivet 17-1, such that the sound wave transmission channel is fastened at the earphone's inlet and the main body's outlet.

To sum up, the sound collecting cavity is a cone body formed by straight line, arc line or curve line, wherein the upper portion of the cone body is cut away, that is a truncated cone. The cone body perfectly collects the sound wave into the sound wave transmission channels.

### Embodiment 2

A safety earphone device comprises an earphone head with cover 1, a sound cavity 2, sound wave transmission channels 3, a main body 4, micro-loudspeaker 5, a microphone 6, a conductor 8 and a plug 9, wherein the channel 3 is placed between the cavities 2 and loudspeaker 5 which is round or ellipse, and the sound wave transmission channel 3 is a length of slim hose or rigid tube. The sound wave transmission channels 3 are made of insulating materials. The micro loudspeaker 5 and the microphone 6 are mounted in the main body 4 in form of one piece. The main body 4 and the micro loudspeaker 5 are located at one end of the sound wave transmission channel 3, while the earphone head with cover 1 at the other end. The slim channel in the middle is the sound wave transmission channels 3. The micro loudspeaker 5, the microphone 6, the conductor 8 and the plug 9 are connected in sequence. The conductor uses metal shield line. The length of sound wave transmission channel 3 is 155 mm; the inner diameter of sound wave transmission channel 3 is 2 mm, the volume of sound cavity 2 is 600mm³; the outlet of the sound cavity 2 is provided with one small hole of 4 mm or several holes with each one having the diameter of 1.5 mm, such that sound cavity forms a small sound box.

The safety earphone device is characterized in:
1 A sound collecting cavity 10 is added between the micro-loudspeaker 5 and the sound wave transmission channel 3; a small sealed box 11 is placed in the main body 4, the loudspeakers 5, the sound collecting cavities 10, and the sound wave transmission channel slot are sealed at the joint into the small sealed box 11, the microphone 6 and a switch 12 are mounted in the main body 4, the sound collecting cavity 10 is of inversed taper shape, and the angles between bevel edges of the two pairs at the periphery of the sound collecting cavity 10 are symmetrical angle of 100°; which means that when the angle is 100°, means that the angle between the bevel/arc/curve edges of the two pairs and the centerline is 50° respectively. Both pairs of angles are of inversed taper shape, or the angles of one pair thereof is of inversed taper while the other pair is parallel; the cross section of the cone or the cross section parallel to the bottom of the cone shape is made of rectangle or polygon shape with the four corners of round or right angle, or the cross section is made of ellipse shape or the cone body has the big end of the rectangle shape and the small end of round shape, or the respective angles between bevel edges of the two pairs at the periphery of the sound collecting cavity 10 and the centerline are unsymmetrical angle of 15° and 50° which means that the angle between the bevel/arc/curve edges of the two pairs at the periphery of the sound collecting cavity 10 and the centerline is unsymmetrical, wherein the angle between left bevel/arc/curve edges and the centerline is 15° while the angle between right bevel/arc/curve edge and the centerline is 50°, or the angle between the left bevel/arc/curve edge and the centerline is 50°, while the angle between right bevel/arc/curve edge and the centerline is 15°.
2 Using one micro-loudspeaker 5, the sound produced by the micro-loudspeaker 5 is transmitted to two sound wave transmission channels via the sound collecting cavity 10 and branch channel, such that it is heard by ears with the earphones inserted.
3 The above loudspeaker is sealed in a small sealed box, the microphone is mounted in one circle hole in the main body with its sound receiving surface facing outward and the periphery sealed, so that the sound can be transmitted to the microphone only through one or more sound receiving holes in the main body and then through one or more sound receiving small holes in front of the sound receiving face of the microphone, therefore, the interference of the loudspeaker on the microphone is eliminated, such that there is no echo or noise produced in the microphone.
4 To improve the tensile strength of the earphone, it is needed to tighten the sound wave transmission channel, which is performed by any one of the two ways as follows:
   One end of the sound wave transmission channel is inserted over the earphone's inlet and the other end thereof over the main body's outlet, and then a jacket 17-2 is used to be inserted over the external diameter of the end of the sound wave transmission channel, for tightening.

### Embodiment 3

A safety earphone device comprises an earphone head with cover 1, a sound cavity 2, sound wave transmission channels 3, a main body 4, micro-loudspeaker 5, a microphone 6, a conductor 8 and a plug 9, wherein the channel 3 is placed between the cavities 2 and loudspeaker 5 which is round or ellipse, and the sound wave transmission channel 3 is a length of slim hose or rigid tube. The sound wave transmission channels are made of insulating materials. The micro loudspeaker 5 and the microphone 6 are mounted in the main body 4 in form of one piece. The main body 4 and the micro loudspeaker 5 are located at one end of the sound wave transmission channel 3 with the earphone head with cover 1 at the other end thereof. The slim channel in the middle is the sound wave transmission channels 3. The micro loudspeaker 5, the microphone 6, the conductor 8 and the plug 9 are connected in sequence. The conductor uses metal shield line. The length of sound wave transmission channel 3 is 600 mm; the inner diameter of sound wave transmission channel 3 is 2mm, the volume of sound cavity 2 is 600mm³; the outlet of the sound cavity 2 is provide with one small hole of 4 mm or several holes with each one having the diameter of 1.5 mm, such that the sound cavity forms a small sound box.

The safety earphone device is characterized in:
1 A sound collecting cavity 10 is added between the micro-loudspeaker 5 and the sound wave transmission channel 3; a small sealed box 11 is placed in the main body 4, the loudspeakers 5, the sound collecting cavities 10, and the sound wave transmission channel port are sealed at the joint into the small sealed box 11, the microphone 6 and a switch 12 are mounted in the main body 4, the sound collecting cavity 10 is of inversed taper shape, the angles between bevel edges of the two pairs at the periphery of the sound collecting cavity 10 are symmetrical angle of 100°; which means that when the angle is 100°, the angles between the bevel/arc/curve edges of the two pairs and the centerline are 50°, both pairs of angles are of inversed taper shape or one pair is of inversed taper while the other pair is parallel; the cross section of the cone or the cross section parallel to the bottom of the cone shape is made of rectangle or polygon shape with the four corners of round or right angle, or the cross section is made of ellipse shape or the cone body has the big end of the rectangle shape and the small end of round shape, or the respective angles between bevel/arc/curve edges of the two pairs at the periphery of the sound collecting cavity 10 and the centerline are unsymmetrical angle of 15° and 50° which means that the angle between the bevel/arc/curve edges of the two pairs at the periphery of the sound collecting cavity 10 and the centerline is unsymmetrical, wherein the angle between left bevel/arc/curve edges and the centerline is 15° while the angle between right bevel/arc/curve edge and the centerline is 50°, or the angle between the left bevel/arc/curve edge and the centerline is 50°, while the angle between right bevel/arc/curve edge and the centerline is 15°.
2 Using one the micro-loudspeaker 5, and the sound produced by the micro-loudspeaker 5 is transmitted to two sound wave transmission channels via the sound collecting cavity 10 and branch channel, such that it is heard by ears with the earphones inserted.
3 The above loudspeaker is sealed in a small sealed box, the microphone is mounted in one circle hole in the main body with its sound receiving surface facing outward and the periphery sealed, so that the sound can be transmitted to the microphone only through one or more sound receiving holes in the main body and then through one or more sound receiving small holes in front of the sound receiving face of the microphone, therefore, the interference of the loudspeaker on the microphone is eliminated, such that there is no echo or noise produced in the microphone.
4 To improve the tensile strength of the earphone, it is needed to tighten the sound wave transmission channel, which is performed by any one of the two ways as follows:
   The sound wave transmission channel 3C has one end fixed in the earphone's inlet and the other end fixed in the main body's outlet, and the slots of the sound wave transmission channel 3C at these two ends are bulged by a hollow rivet 17-1, such that the sound wave transmission channel is fastened at the earphone's inlet and the main body's outlet.

### Embodiment 4

A safety earphone device comprises an earphone head with cover 1, a sound cavity 2, sound wave transmission channels 3, a main body 4, micro-loudspeaker 5, a microphone 6, a conductor 8 and a plug 9, wherein the channel 3 is placed between the cavities 2 and loudspeaker 5, the sound wave transmission channel 3 is a length of slim hose or rigid tube. The sound wave transmission channels are made of insulating materials. The main body 4, the micro loudspeaker 5 and the microphone 6 are mounted in the main body 4 in form of one piece. The main body 4 and the micro loudspeaker 5 are located at one end of the sound wave transmission channel 3 with the earphone head with cover 1 at the other end thereof. The slim channel in the middle is the sound wave transmission channels 3. The micro loudspeaker 5, the microphone 6, the conductor 8 and the plug 9 are connected in sequence. The conductor uses metal shield line. The length of sound wave transmission channel 3 is 155 mm; the inner diameter of sound wave transmission channel 3 is 2 mm, the volume of sound cavity 2 is 600mm³; the outlet of the sound cavity 2 is provide with one small hole of 2 mm or several holes with each one having the diameter of 1.0 mm, such that sound cavity forms a small sound box.

The safety earphone device is characterized in that:
1 A sound collecting cavity 10 is added between the micro-loudspeaker 5 and the sound wave transmission channel 3; a small sealed box 11 is placed in the main body 4, the loudspeakers 5, the sound collecting cavities 10, and the sound wave transmission channel slot are sealed at the joint into the small sealed box 11, the microphone 6 and a switch 12 are mounted in the main body 4, the sound collecting cavity 10 is of inversed taper shape or reverse port form, the angles between bevel edges of the two pairs at the periphery of the sound collecting cavity 10 are symmetrical angle of 130°, both pairs of angles are of inversed taper shape or one pair is of inversed taper while the other pair is parallel; the cross section of the cone of the cone shape has four corners of round or right angle, wherein symmetrical angle of 130° means that the angle is 130° wherein the respective angles between bevel/arc/curve edges of the two pairs and the centerline are 65°, or the respective angles between bevel/arc/curve edges of the two pairs at the periphery of the sound collecting cavity 10 and the centerline are the unsymmetrical angle of 25° and 40° which means that the angle between the bevel/arc/curve edges of the two pairs at the periphery of the sound collecting cavity 10 and the centerline is unsymmetrical, wherein the angle between left bevel/arc/curve edges and the centerline is 25° while the angle between right bevel/arc/curve edge and the centerline is 40°, or the angle between the left bevel/arc/curve edge and the centerline is 40°, while the angle between right bevel/arc/curve edge and the centerline is 25°.
2 Using one micro-loudspeaker 5, and the sound produced by the micro-loudspeaker 5 is transmitted to two sound wave transmission channels via the sound collecting cavity 10 and branch channel, such that it is heard by ears with the earphones inserted.
3 The above loudspeaker is sealed in a small sealed box, the microphone is mounted in one circle hole in the main body with its sound receiving surface facing outward and the periphery sealed, so that the sound can be transmitted to the microphone only through one or more sound receiving holes in the main body and then through one or more sound receiving small holes in front of the sound receiving face of the microphone, therefore, the interference of the loudspeaker on the microphone is eliminated, such that there is no echo or noise produced in the microphone.
4 To improve the tensile strength of the earphone, it is needed to tighten the sound wave transmission channel, which is performed by any one of the two ways as follows:
   One end of the sound wave transmission channel is inserted over the earphone's inlet and the other end thereof over the main body's outlet, and then a jacket 17-2 is used to be inserted over the external diameter of the end of the sound wave transmission channel, for tightening.

### Embodiment 5

The safety earphone device is characterized in that: besides that the sound collecting cavity 10 is of inverse taper shape, said inverse taper shape can be as the following:
1 The inversed taper shape with the peripheral formed by arc lines;
2 The inversed taper shape with the peripheral formed by bevel lines;
3 The inversed taper shape with the peripheral formed by curve lines;
4 The inversed taper shape with the peripheral formed by arc or curve lines and bevel lines all together.

The angles between the bevel/arc/curve edges of the two pairs at the periphery of the sound collecting cavity 10 and the central line are the unsymmetrical angles of 60°, meaning that the angles between the bevel/arc/curve edges of two pairs at the periphery of the sound collecting cavity 10 and the centerline are unsymmetrical wherein the angle between the left bevel/arc/curve edge and the centerline is 51° while the angle between the right bevel/arc/curve edge and the centerline is 9°, or vice versa. Except the above, the present embodiment has the same structure with that of any of the Embodiments 1-4.

### Embodiment 6

The safety earphone device is characterized in that: the present embodiment has the same structure with that of anyone of Embodiments 1-4, except that the angles between the bevel/arc/curve edges of the two pairs at the periphery of the sound collecting cavity 10 and the central line are the unsymmetrical angles of 40°, meaning that the angles between the bevel/arc/curve edges of two pairs at the periphery of the sound collecting cavity 10 and the centerline are unsymmetrical wherein the angle between the left bevel/arc/curve edge and the centerline is 35° while the angle between the right bevel/arc/curve edge and the centerline is 5°, or vice versa.

### Embodiment 7

The safety earphone device is characterized in that: the present embodiment has the same structure with that of any of Embodiments 1-6, except that the angles between the bevel/arc/curve edges of the two pairs at the periphery of the sound collecting cavity 10 and the central line are 18° (symmetrical).

### Embodiment 8

The safety earphone device is characterized in that: the present embodiment has the same structure with that of any of Embodiments 1-6, except that the angles between the bevel/arc/curve edges of the two pairs at the periphery of the sound collecting cavity 10 and the central line are the unsymmetrical angles of 60°, meaning that the respective angles between the bevel/arc/curve edges of two pairs at the periphery of the sound collecting cavity 10 and the centerline are unsymmetrical wherein the angle between the left bevel/arc/curve edge and the centerline is 51° while the angle between the right bevel/arc/curve edge and the centerline is 9°, or vice versa.

### Embodiment 9

The safety earphone device is characterized in that: the present embodiment has the same structure with that of Embodiments 1-6, except that the angles between the bevel/arc/curve edges of the two pairs at the periphery of the sound collecting cavity 10 and the central line are, 120° (symmetrical).

### Embodiment 10

The safety earphone device is characterized in that: the present embodiment has the same structure with that of any of Embodiments 1-6, except that the angles between the bevel/arc/curve edges of the two pairs at the periphery of the sound collecting cavity 10 and the central line are, 100° (symmetrical).

### Embodiment 11

The safety earphone device is characterized in that: the present embodiment has the same structure with that of any of Embodiments 1-10, except that the micro-loudspeaker 5 is placed vertically in main body 4.

### Embodiment 12

The safety earphone device is characterized in that: the present embodiment has the same structure with that of any of Embodiments 1-10, except that the micro-loudspeaker 5 is placed flatly or slantwise in the main body 4.

### Embodiment 13

The safety earphone device is characterized in that: the present embodiment has the same structure with that of any of Embodiments 1-12, except that there are two micro-loudspeakers 5, i.e. 5A and5B.

The embodiments described above is for better understanding of the principles of the present invention.

It should be noted that the above embodiments are provided for describing the present invention in detail, but not intended to limit the scope of the present invention. Without departing from the scope of the present invention, those skilled in the art can make various improvements and modifications, within the scope as defined by the appended claims.

## Claims

1. A safety earphone comprising:
an earphone head (1), provided therein with a sound cavity (2) which has a first end having a sound outlet,
a main body (4), provided therein with a sound collecting cavity (10) with a channel opening wherein the channel opening is connected to a second end of the sound cavity (2) through a sound wave transmission channel (3),
a micro-loudspeaker (5), wherein the sound collecting cavity (10) is between a sounding end of the micro-loudspeaker (5) and the sound wave transmission channel (3),
wherein the micro-loudspeaker is connected with a first end of a conductor (8) outside the main body (4) and a second end of the conductor (8) is connected with a plug (9),
wherein the sound collecting cavity (10) is of the inversed taper shape,
wherein the main body (4) is provided therein with a microphone (6), the main body (4) has a sound receiver hole (13) corresponding to the microphone (6),
wherein a small sealed box (11) is placed in the main body (4), defining the sound collecting cavity (10) therein, wherein both ends of the small sealed box are sealingly connected with the periphery of the sounding end of the micro-loudspeakers (5) and the channel opening respectively, such that the sound wave from the micro-loudspeaker is transmitted to the sound cavity (2) through the sound collecting cavity (10) and then through the sound wave transmission channel (3),
**characterized in**:
wherein the microphone (6) is mounted in a round hole in the main body (4) with a sound receiving face of the microphone (6) facing outward and the periphery of the microphone sealed, so that the sound is transmitted to the microphone (6) through a microphone cavity located between the sound receiver hole on the main body (4) and a sound receiving hole (14) in front of the sound receiving face of the microphone (6).

2. The safety earphone according to claim 1, wherein the sound wave transmission channel (3) is a tube made of insulating material with the inner diameter of 2mm-4mm and the length of 110mm-600mm, the volume of the sound cavity (2) is 600mm³-3000mm³, the sound outlet is one hole with the diameter of Φ 0,3mm-1,5mm.

3. The safety earphone according to claim 2, wherein the sound wave transmission channel (3) is 155mm-600mm in length.

4. The safety earphone according to claim 1, wherein a longitudinal section of the sound collecting cavity (10) defines at least a pair of symmetric lines.

5. The safety earphone according to claim 1, wherein a longitudinal section of the sound collecting cavity (10) defines asymmetric lines.

6. The safety earphone according to claim 1, wherein a longitudinal section of the sound collecting cavity (10) defines one of the following:
1) arc-shaped lines;
2) bevel-shaped lines;
3) curve-shaped lines;
4) arc-shaped or curve-shaped lines and bevel-shaped lines.

7. The safety earphone according to claim 1, wherein a cross section of the sound collecting cavity (10) is of ellipse, round or rectangle shape, or polygon shape with each adjacent two edges connected by an arc.

8. The safety earphone according to claim 1, wherein the number of the micro-loudspeaker (5) is 1, the number of the sound collecting cavity (10) is 1, and the number of the channel openings is 2 wherein the sound from the micro-loudspeakers (5) is transmitted respectively into two earphone heads (1) via two sound wave transmission channels (3) connected with the two channel openings.

9. The safety earphone according to claim 1, wherein the sound wave transmission channel (3) has one end fixed in an earphone's inlet and the other end in a main body's outlet; a port of each end of the sound wave transmission channel (3) is bulged by a hollow rivet (17-1) inserted therein, to tighten both ends of the sound wave transmission channel to the main body's outlet and the earphone's inlet.

10. The safety earphone according to claim 1, wherein the sound wave transmission channel (3) has one end inserted over a main body's outlet while the other end over an earphone's inlet; and both ends of the sound wave transmission channel (3) are sheathed with a jacket (17-2) outside, for tightening.

11. The safety earphone according to claim 1, wherein the quantity of the small sealed boxes (11) is equal to the quantity of the sound collecting cavities (10).

12. The safety earphone according to claim 1, wherein the number of the micro-loudspeaker (5) is 1, the number of the sound collecting cavity (10) is 1, and the number of the channel opening is 1 wherein the sound from the micro-loudspeakers (5) is transmitted respectively into the one earphone head (1) via the sound wave transmission channels (3) connected with the channel opening.

13. The safety earphone according to claim 1, wherein the number of the micro-loudspeakers (5) is 2, the number of the sound collecting cavities (10) is 2, wherein one micro-loudspeaker corresponds to one sound collecting cavity (10) and each sound collecting cavity is provided with one channel opening, and one channel opening corresponds to one earphone head.

14. The safety earphone according to claim 2, wherein the micro-loudspeaker (5) is of round or ellipse shape.

## Patentansprüche

1. Sicherheits-Ohrhörer, umfassend:
einen Ohrhörerkopf (1), ausgestattet darin mit einer Schallkammer (2) welche ein erstes Ende mit einer Schallöffnung hat,
ein Hauptteil (4), ausgestattet darin mit einem Schallauffangraum (10) mit einer Kanalöffnung, wobei die Kanalöffnung durch einen Schallwellenübertragungskanal (3) mit einem zweiten Ende der Schallkammer (2) verbunden ist,
einen Mikrolautsprecher (5), wobei der Schallauffangraum (10) sich zwischen einem schallerzeugenden Ende des Mikrolautsprechers (5) und dem Schallwellenübertragungskanal (3) befindet,
wobei der Mikrolautsprecher mit einem ersten Ende eines Leiters (8) außerhalb des Hauptteils (4) verbunden ist und ein zweites Ende des Leiters (8) mit einem Stecker (9) verbunden ist,
wobei der Schallauffangraum (10) eine umgekehrte Kegelform hat,
wobei das Hauptteil (4) darin ausgestattet ist mit einem Mikrofon (6), und das Hauptteil (4) eine dem Mikrofon (6) entsprechende Schallaufnahmeöffnung (13) hat,
wobei ein kleiner abgedichteter Kasten (11) im Hauptteil (4) angeordnet ist, der den Schallauffangraum (10) darin definiert, wobei beide Enden des kleinen abgedichteten Kastens jeweils dicht mit der Peripherie des schallerzeugenden Endes der Mikrolautsprecher (5) und der Kanalöffnung verbunden sind, so dass die Schallwelle vom Mikrolautsprecher durch den Schallauffangraum (10) und dann durch den Schallwellenübertragungskanal (3) zur Schallkammer (2) übertragen wird,
**gekennzeichnet durch**:
wobei das Mikrofon (6) mit einer Schall empfangenden Seite des Mikrofons (6) nach außen gerichtet und abgedichteter Peripherie des Mikrofons in einer runden Öffnung im Hauptteil (4) montiert ist, so dass der Schall durch einen Mikrofonhohlraum, angeordnet zwischen der Schallaufnahmeöffnung am Hauptteil (4) und einer Schallaufnahmeöffnung (14) vor der Schall empfangenden Seite des Mikrofons (6), zum Mikrofon (6) übertragen wird.

2. Sicherheits-Ohrhörer gemäß Anspruch 1, wobei der Schallwellenübertragungskanal (3) ein Schlauch aus isolierendem Material mit dem Innendurchmesser von 2mm-4mm und der Länge von 110mm-600mm ist, das Volumen der Schallkammer (2) 600mm3-3000mm3 ist, der Schallauslass ein Loch mit dem Durchmesser von Φ 0,3mm-1,5mm ist.

3. Sicherheits-Ohrhörer gemäß Anspruch 2, wobei der Schallwellenübertragungskanal (3) eine Länge von 155mm-600mm hat.

4. Sicherheits-Ohrhörer gemäß Anspruch 1, wobei ein Längsschnitt des Schallauffangraums (10) zumindest ein Paar symmetrischer Linien definiert.

5. Sicherheits-Ohrhörer gemäß Anspruch 1, wobei ein Längsschnitt des Schallauffangraums (10) asymmetrische Linien definiert.

6. Sicherheits-Ohrhörer gemäß Anspruch 1, wobei ein Längsschnitt des Schallauffangraums (10) eines der folgenden definiert:
1) bogenförmige Linien;
2) fasenförmige Linien;
3) kurvenförmige Linien;
4) bogenförmige oder kurvenförmige Linien und fasenförmige Linien.

7. Sicherheits-Ohrhörer gemäß Anspruch 1, wobei ein Querschnitt des Schallauffangraums (10) elliptische, runde oder rechteckige Form hat, oder Polygonform hat, bei der jeweils zwei benachbarte Kanten durch einen Bogen verbunden sind.

8. Sicherheits-Ohrhörer gemäß Anspruch 1, wobei die Anzahl der Mikrolautsprecher (5) 1 ist, die Anzahl der Schallauffangräume (10) 1 ist, und die Anzahl der Kanalöffnungen 2 ist, wobei der Schall von den Mikrolautsprechern (5) jeweils über zwei Schallwellenübertragungskanäle (3), die mit den zwei Kanalöffnungen verbunden sind, in zwei Ohrhörerköpfe (1) übertragen wird.

9. Sicherheits-Ohrhörer gemäß Anspruch 1, wobei ein Ende des Schallwellenübertragungskanals (3) in dem Eingang eines Ohrhörers und das andere Ende in dem Ausgang eines Hauptteils fixiert ist; eine Öffnung an jedem Ende des Schallwellenübertragungskanals (3) durch einen darin eingesetzten Hohlniet (17-1) gewölbt ist, um beide Enden des Schallwellenübertragungskanals zum Ausgang des Hauptteils und zum Eingang des Ohrhörers festzuziehen.

10. Sicherheits-Ohrhörer gemäß Anspruch 1, wobei ein Ende des Schallwellenübertragungskanals (3) über den Ausgang eines Hauptteils eingesetzt ist, während das andere Ende über den Eingang eines Ohrhörers eingesetzt ist; und beide Enden des Schallwellenübertragungskanals (3) zum Festziehen außen mit einem Mantel (17-2) umhüllt sind.

11. Sicherheits-Ohrhörer gemäß Anspruch 1, wobei die Anzahl der kleinen abgedichteten Kästen (11) gleich der Anzahl der Schallauffangräume (10) ist.

12. Sicherheits-Ohrhörer gemäß Anspruch 1, wobei die Anzahl der Mikrolautsprecher (5) 1 ist, die Anzahl der Schallauffangräume (10) 1 ist und die Anzahl der Kanalöffnungen 1 ist, wobei der Schall von den Mikrolautsprechern (5) jeweils über die mit der Kanalöffnung verbundenen Schallwellenübertragungskanäle (3) in den einen Ohrhörerkopf (1) übertragen wird.

13. Sicherheits-Ohrhörer gemäß Anspruch 1, wobei die Anzahl der Mikrolautsprecher (5) 2 ist, die Anzahl der Schallauffangräume (10) 2 ist, wobei ein Mikrolautsprecher einem Schallauffangraum (10) zugeordnet ist und jeder Schallauffangraum über eine Kanalöffnung verfügt, und eine Kanalöffnung einem Ohrhörerkopf zugeordnet ist.

14. Sicherheits-Ohrhörer gemäß Anspruch 2, wobei der Mikrolautsprecher (5) eine runde oder elliptische Form hat.

## Revendications

1. Ecouteur de sécurité comprenant:
une tête d'écouteur (1), munie à l'intérieur d'une cavité sonore (2) qui présente une première extrémité ayant une sortie sonore,
un corps principal (4), pourvu à l'intérieur d'une cavité collectrice de sons (10) avec une ouverture de canal dans laquelle l'ouverture de canal est reliée à une seconde extrémité de la cavité sonore (2) par un canal de transmission des ondes sonores (3),
un microhaut-parleur (5), dans lequel la cavité collectrice de son (10) se trouve entre une extrémité de sondage du microhaut-parleur (5) et le canal de transmission des ondes sonores (3),
dans lequel le microhaut-parleur est relié à une première extrémité d'un conducteur (8) à l'extérieur du corps principal (4) et une seconde extrémité du conducteur (8) est reliée à une fiche (9),
dans lequel la cavité collectrice de sons (10) a la forme conique inversée,
dans lequel le corps principal (4) est muni d'un microphone (6), le corps principal (4) a un trou de récepteur de son (13) correspondant au microphone (6),
dans lequel une petite boîte scellée (11) est placée dans le corps principal (4), définissant la cavité collectrice de sons (10) à l'intérieur de celle-ci, dans lequel les deux extrémités de la petite boîte scellée sont reliées de manière étanche à la périphérie de l'extrémité sonore des microhaut-parleurs (5) et à l'ouverture du canal respectivement, de sorte que les ondes sonores du micro haut-parleur sont transmises dans la cavité sonore (2) via la cavité collectrice de sons (10) et ensuite via le canal de transmission des ondes sonores (3),
**caractérisé en ce que** :
dans lequel le microphone (6) est monté dans un trou rond dans le corps principal (4) avec une face de réception du son du microphone (6) tournée vers l'extérieur et la périphérie du microphone scellée, de sorte que le son est transmis au microphone (6) par une cavité de microphone située entre le trou du récepteur de son du corps principal (4) et un trou de réception du son (14) devant la face de réception du son du microphone (6).

2. Ecouteur de sécurité selon la revendication 1, dans lequel le canal de transmission d'ondes sonores (3) est un tube en matériau isolant ayant un diamètre intérieur de 2mm - 4mm et une longueur de 110mm - 600mm, le volume de la cavité sonore (2) est de 600mm^3 - 3000mm^3, la sortie sonore est un trou ayant le diamètre Φ de 0,3mm - 1,5mm.

3. Ecouteur de sécurité selon la revendication 2, dans lequel le canal de transmission des ondes sonores (3) a une longueur de 155 mm à 600 mm.

4. Ecouteur de sécurité selon la revendication 1, dans lequel une section longitudinale de la cavité collectrice de sons (10) définit au moins une paire de lignes symétriques.

5. Ecouteur de sécurité selon la revendication 1, dans lequel une section longitudinale de la cavité collectrice de son (10) définit des lignes asymétriques.

6. Ecouteur de sécurité selon la revendication 1, dans lequel une section longitudinale de la cavité collectrice de sons (10) définit l'un des éléments suivants:
1) lignes en forme d'arc;
2) lignes biseautées;
3) lignes courbes;
4) lignes en forme d'arc ou de courbe et lignes en biseau.

7. Ecouteur de sécurité selon la revendication 1, dans lequel une section transversale de la cavité collectrice de sons (10) est de forme elliptique, ronde ou rectangulaire, ou de forme polygonale avec chaque deux bords adjacents reliés par un arc.

8. Ecouteur de sécurité selon la revendication 1, dans lequel le numéro du microhaut-parleur (5) est 1, le numéro de la cavité collectrice de son (10) est 1, et le nombre des ouvertures de canal est 2, dans lequel le son des microhaut-parleurs (5) est transmis respectivement dans deux écouteurs (1) via deux canaux de transmission des ondes sonores (3) connectés avec les deux ouvertures de canal.

9. Ecouteur de sécurité selon la revendication 1, dans lequel le canal de transmission d'ondes sonores (3) a une extrémité fixée dans l'entrée d'un écouteur et l'autre extrémité dans la sortie d'un corps principal; un orifice de chaque extrémité du canal de transmission d'ondes sonores (3) est bombé par un rivet creux (17-1) inséré dedans, pour tendre les deux extrémités du canal de transmission des ondes sonores vers la sortie du corps principal et l'entrée du casque.

10. Ecouteur de sécurité selon la revendication 1, dans lequel le canal de transmission d'ondes sonores (3) a une extrémité insérée au-dessus de la sortie d'un corps principal et l'autre extrémité au-dessus de l'entrée d'un écouteur; et les deux extrémités du canal de transmission d'ondes sonores (3) sont gainées avec une gaine (17-2) à l'extérieur, pour serrage.

11. Ecouteur de sécurité selon la revendication 1, dans lequel la quantité des petites boîtes scellées (11) est égale à la quantité des cavités collectrices de sons (10).

12. Ecouteur de sécurité selon la revendication 1, dans lequel le numéro du microhaut-parleur (5) est 1, le numéro de la cavité collectrice de son (10) est 1, et le numéro de l'ouverture de canal est 1, dans lequel le son des microhaut-parleurs (5) est transmis respectivement dans la tête (1) d'écouteur via les canaux (3) de transmission des ondes sonores reliés à l'ouverture de canal.

13. Ecouteur de sécurité selon la revendication 1, dans lequel le nombre des microhaut-parleurs (5) est de 2, le nombre des cavités collectrices de sons (10) est de 2, dans lequel un microhaut-parleur correspond à une cavité collectrice de sons (10) et chaque cavité collectrice de sons est munie d'une ouverture pour canal, et une ouverture pour canal correspond à une tête pour écouteur.

14. Ecouteur de sécurité selon la revendication 2, dans lequel le microhaut-parleur (5) est de forme ronde ou elliptique.
